## Europäisches Patentamt

## European Patent Office

## Office européen des brevets

(11) Numéro de publication : **0 054 598**
**B1**

## (12) FASCICULE DE BREVET EUROPÉEN

(45) Date de publication du fascicule du brevet :
03.04.85

(51) Int. Cl.⁴ : **G 01 N 21/88, H 05 K 13/08**

(21) Numéro de dépôt : **80430033.3**

(22) Date de dépôt : **18.12.80**

(54) Procédé d'inspection et de tri automatique d'objets présentant des configurations avec des tolérances dimensionnelles fixes et équipement de mise en oeuvre.

(43) Date de publication de la demande :
30.06.82 Bulletin 82/26

(45) Mention de la délivrance du brevet :
03.04.85 Bulletin 85/14

(84) Etats contractants désignés :
DE FR GB

(56) Documents cités :
EP-A- 0 004 505
FR-A- 2 095 523
FR-A- 2 249 520
FR-A- 2 321 229
US-A- 3 956 629
US-A- 4 123 170
US-A- 4 218 142
SOLID STATE TECHNOLOGY, vol. 23, no. 10, Octobre 1980, L. ARLAN et al. "Computer controlled imaging system for automatic hybrid inspection", pages 123 à 129
COMPUTER GRAPHICS AND IMAGE PROCESSING, vol. 4, 1975, L.S. DAVIS "A survey of edge detection techniques", pages 248 à 270

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Linger, Claude Jacques André**
**13, rue des Haies**
**F-75020 Paris (FR)**
Inventeur : **Locicero, Gisèle, Christiane, M.**
**1 bis, chemin des Vieilles Portes**
**F-91000 Evry (FR)**

(74) Mandataire : **Klein, Daniel Jacques Henri**
**Compagnie IBM France Département de Propriété Industrielle**
**F-06610 La Gaude (FR)**

Jouve, 18, rue St-Denis, 75001 Paris, France

EP 0 054 598 B1

**0 054 598**

**Description**

### Domaine Technique

La présente invention concerne un procédé d'inspection sans contact et de tri automatique d'objets présentant des tolérances dimensionnelles fixes, et son équipement de mise en œuvre. Elle concerne plus particulièrement un procédé d'inspection sans contact et de tri automatique d'objets présentant des configurations ayant des tolérances dimensionnelles fixes, tels que les circuits imprimés, les masques, les modules et les microplaquettes de circuits intégrés, employés dans l'industrie des semiconducteurs, qui utilise les tranformations de base de la morphologie mathématique et de la théorie des ensembles. Elle concerne également son équipement de mise en œuvre réalisé autour d'un ordinateur numérique.

### Etat de la technique antérieure

De nombreux procédés basés sur le principe de la comparaison entre un objet de référence, conforme aux spécifications et un objet similaire à examiner, dont la conformité doit être vérifiée, existent à ce jour. On pourra en particulier se référer aux documents suivants :

Le brevet FR-A-2 249 520 (Westinghouse) décrit un procédé consistant : à balayer l'objet de référence avec un détecteur d'infrarouge, à balayer l'objet à examiner à l'aide d'un détecteur d'infrarouge, à comparer les signaux engendrés par l'objet de référence et par l'objet examiné pour déceler toute différence entre ces signaux, et à analyser statistiquement toute différence pour déterminer si l'objet subissant l'examen est opérationnel dans des limites prescrites.

Ce brevet décrit également un appareil comprenant : des moyens pour inspecter l'objet de référence selon un paramètre déterminé pour engendrer des données de référence, en détectant ce paramètre, des moyens pour inspecter l'objet devant être examiné dans le but d'engendrer des données d'essais en détectant ce paramètre, des moyens pour comparer lesdites données de référence et lesdites données d'essais dans le but d'engendrer des données de comparaison en relation avec la différence entre les données de référence et les données d'essais et des moyens pour analyser statistiquement les données de comparaison pour déterminer l'état opérationnel de l'objet en cours d'inspection.

Pratiquement cet appareil est destiné à détecter les radiations infrarouges émises par un circuit électronique et à analyser ces radiations pour déterminer si le circuit fonctionne correctement. La procédure de base utilisée consiste donc à sélectionner un circuit de référence fonctionnant correctement. Le circuit de référence est mis en place dans un équipement de fixation et on lui applique des tensions normales de polarisation et des signaux d'entrée sélectionnés. La surface du circuit de référence est analysée par une caméra de télévision sensible aux rayons infrarouges pour engendrer un signal vidéo proportionnel à la radiation infrarouge émise. On prélève des échantillons de signal vidéo et chaque échantillon est converti en « numérique » pour engendrer un premier réseau de nombres numériques dont la valeur de chacun d'eux est proportionnelle à la radiation infrarouge émise par une portion spécifique du circuit. Ces nombres numériques sont ensuite emmagasinés dans une mémoire numérique.

Le circuit devant être inspecté est ensuite placé dans l'équipement de fixation et est raccordé de la même façon que le circuit de référence afin de recevoir une tension de polarisation et des signaux d'entrée pratiquement identiques à ceux appliqués précédemment à celui-ci. La surface du circuit à examiner est alors analysée et traitée de façon identique et fournit un second réseau de nombres numériques qui sont également emmagasinés dans la mémoire numérique.

Un dispositif de traitement numérique lit les premier et second réseaux de nombres numériques se trouvant dans la mémoire et compare les éléments correspondants desdits premier et second réseaux pour engendrer un troisième réseau de nombres numériques. Chaque élément de ce troisième réseau est proportionnel à la différence entre les éléments correspondants des premier et second réseaux. Ce troisième réseau de nombres numériques est ensuite analysé pour indiquer les zones où la radiation infrarouge émise par le circuit en cours d'examen est sensiblement différente de celle émise par la position correspondante du circuit témoin. L'existence de différences sensibles indique que le circuit à examiner, ne fonctionne pas correctement.

Le brevet ci-dessus est caractéristique de la technique de comparaison selon un paramètre électrique déterminé (ici le passage du courant), entre un objet de référence et un objet similaire à examiner. S'agissant de comparer selon le même principe, des configurations de dessins, le brevet français FR-A-2 095 523 (IBM) montre un appareil de détection de défauts par balayage optique. Cet appareil trouve essentiellement application dans le domaine de la fabrication de photo-masques. Cet appareil ne peut fonctionner que si l'objet à examiner présente des configurations répétitives ; en outre l'objet de référence, est un objet spécial, qui n'appartient pas à la famille des objets à examiner, et qui est donc construit spécialement pour tenir compte de certaines spécificités de l'objet à examiner.

La référence FR-A-2 321 229 décrit un procédé et un appareillage pour le contrôle automatique de dessins notamment dans le domaine des circuits imprimés, basé sur la comparaison de l'image du dessin à examiner avec l'image du dessin échantillon. Les images analogiques fournies par les deux caméras sont seuillées pour les transformer en images binaires. La comparaison des signaux binaires est effectuée dans un circuit spécialisé et le signal binaire qui en résulte est représentatif de la présence ou de l'absence de défauts.

La référence EP-A-4505 décrit également un système de contrôle dé dessins basé sur un même principe avec un balayage ligne par ligne des objets à examiner et échantillonner.

## Exposé de l'invention

Un premier but de l'invention est de proposer un procédé et un équipement qui permettent l'inspection et le tri d'objets présentant des configurations avec des tolérances dimensionnelles fixes permettant de déterminer si l'objet à examiner est opérationnel dans des limites prescrites, à partir de critères de rejet préalablement déterminés.

Un autre but de l'invention est de proposer un procédé et un équipement qui permettent d'automatiser l'inspection et le tri d'objets présentant des configurations présentant des tolérances dimensionnelles fixes qui évitent de recourir au tri optique manuel.

Encore un autre but de l'invention est de proposer un procédé et un équipement de détection de défauts, d'un objet à examiner, à partir d'un objet de référence de la même famille.

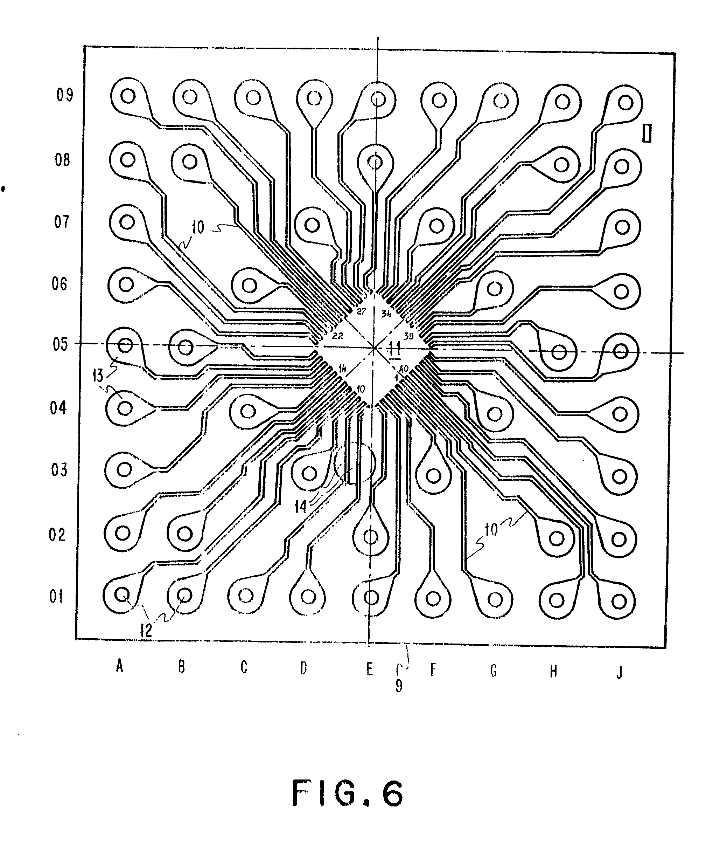

Dans la présente demande, pour la simplification de l'exposé, seule l'application au tri des modules céramiques (du genre de celui représenté sur la figure 6) sera détaillée. L'adaptation du procédé de la présente invention à d'autres objets présentant des tolérances fixes couramment employés dans l'industrie des semi-conducteurs, tels que : masques, réticules, cartes de circuits imprimés, microplaquettes de circuits intégrés, est sans difficulté majeure pour l'homme de l'art. La présente invention s'attache essentiellement aux configurations géométriques des objets, et n'est donc pas limitée à ce seul domaine d'application.

Le problème à la base de l'invention est résolu de la manière indiquée dans la partie caractérisante de la revendication 1 relative à un procédé de tri automatique d'objets présentant des configurations avec des tolérances dimensionnelles fixes. Ce procédé comporte essentiellement une étape complexe de mise en évidence des défauts présentés par l'objet à examiner par comparaison de l'image de l'objet de référence (en temps réel ou préalablement stockée sous forme numérique dans une mémoire) et de l'image de l'objet à examiner. Cette comparaison s'effectue à l'aide d'un traitement numérique précis de l'image qui met en œuvre des transformations de base de la morphologie mathématique et de la théorie des ensembles.

Les deux images sont relevées, par exemple, en noir et blanc avec tous les niveaux de gris selon une trame d'échantillonnage appropriée, puis quantifiées avec seize niveaux de gris.

Les images sont alors seuillées pour n'apparaître qu'en noir et blanc, par exemple les motifs à comparer sont blancs sur un fond noir. Cette étape peut se faire à l'aide d'un programme informatique. On obtient finalement deux images binaires de l'objet de référence et de l'objet échantillon.

Ces images binaires, après avoir été nettoyées (élimination du bruit) et cadrées sont comparées.

Pour mettre en évidence les défauts au regard des tolérances dimensionnelles, il faut comparer l'image de l'échantillon aux images de référence maximale et minimale.

La création de ces deux images se fait par dilatation et érosion (transformation de base de la morphologie mathématique), de l'image de référence nominale. Les tailles de dilatation et d'érosion sont fonction de la largeur des tolérances dimensionnelles maximales et minimales des circuits. Celles-ci sont fixes pour des conducteurs de même largeur sur toute la surface du module. La comparaison de l'image de l'échantillon avec l'image de référence minimale donne les défauts du genre « manque », c'est-à-dire hors les tolérances dimensionnelles minimales.

La comparaison de l'image de l'échantillon avec l'image de référence maximale donne les défauts du genre « extension », c'est-à-dire hors les tolérances dimensionnelles maximales.

La comparaison des images se fait par diverses opérations de la théorie des ensembles (union, intersection, etc.) qui correspondent aux opérations booléennes ET, OU, OU EXC, Inversion. Les opérations de comparaison ainsi que celles d'érosion et de dilatation peuvent se faire à l'aide de programmes informatiques.

L'étape d'analyse selon les critères de rejet de ces images des défauts, est suivi par une étape de tri qui permet de rejeter les objets qui présentent des défauts non désirés.

Des caractéristiques particulières de ce procédé sont décrites dans les sous revendications 2 à 11.

La présente invention concerne également un équipement pour la mise en œuvre de ce procédé, qui fait l'objet de la revendication 12. Des caractéristiques particulières propres à cet équipement sont décrites dans les revendications 13 à 18...

D'autres buts, caractéristiques et avantages de la présente invention ressortiront mieux de l'exposé qui suit, fait en référence aux dessins annexés à ce texte, qui représentent un mode de réalisation préféré de celle-ci.

## Brève description des figures

La figure 1 représente l'organigramme des différentes étapes du procédé d'inspection et de tri de la présente invention.

La figure 2 représente les histogrammes de la distribution des points « image » (pixels) selon l'amplitude du signal pour deux images, une très contrastée et l'autre peu contrastée, en noir et blanc avec seize niveaux de gris.

La figure 3 représente respectivement deux motifs de l'image de l'objet de référence et l'image de l'objet à examiner qui doivent être cadrées.

La figure 4 représente la courbe I(Mx) qui représente la surface hachurée montrée sur la figure 3 et qui est porportionnelle au décalage Mx des motifs et sa variation en fonction du déplacement de l'objet à examiner.

La figure 5 représente de façon similaire la courbe I(My).

La figure 6 représente une topologie de conducteurs à largeur fixe à la surface d'un module céramique de 48 broches destiné à recevoir une unique microplaquette de circuits intégrés.

La figure 7 représente différents défauts du genre « extension ».

La figure 8 représente différents défauts du genre « manque ».

La figure 9 représente les différentes transformations et opérations logiques subies par les images de l'objet de référence et l'objet à examiner pour aboutir aux images des défauts des deux genres.

La figure 10 représente schématiquement le bloc diagramme de l'équipement mettant en évidence les différents éléments qui le composent.

Les figures 11A, B, C et D représentent schématiquement les différents circuits logiques utilisés pour l'unité de traitement.

La figure 12 représente le bloc diagramme de l'unité de traitement.

## Description de l'invention

### I. Eléments de morphologie mathématique

Les définitions des différentes transformations de base utilisées dans le traitement numérique de l'image conformément aux enseignements de la présente invention reposent principalement sur les notions d'élément structurant et de transformations par tout ou rien : érosion ou dilatation. L'espace sur lequel on travaille est l'espace euclidien R2 muni de sa métrique d. 0 désigne l'origine de l'espace considéré. Si B désigne un ensemble quelconque de cet espace, $B_x$ désigne le translaté de B par le vecteur $\vec{Ox}$, on définit

a) la dilatation

Soient A et B deux ensembles de R2, on appelle dilaté de A par B un nouvel ensemble noté A ⊕ B tel que :

$$A \oplus B = \{ x \in R2 \mid B_x \cap A \neq \emptyset \}$$

en d'autres termes un point x de l'espace R2 appartient au dilaté de A par B si et seulement si le translaté de B par $\vec{Opx}$ rencontre A. L'ensemble B est appelé l'élément structurant.

b) l'érosion

Soient A et B deux ensembles de R2. On appelle érodé de A par B l'ensemble noté A ⊖ B tel que

$$A \ominus B = \{ X \in R2 \mid B_x \subset A \}$$

un point x de l'espace R2 appartient à l'érodé de A par B si et seulement si l'ensemble $B_x$ est totalement inclus dans A.

c) dilatation et érosion circulaire

C'est l'hypothèse où l'élément structurant est un cercle.
On note

$$D(x,\rho) = \{y \in R2 \mid d(x,y) \leq \rho \}$$

le disque de centre x et de rayon ρ. En d'autres termes un point y de l'espace R2 appartient au disque si la distance qui sépare ce point du centre est inférieure ou égale au rayon.

La distance entre un point x et un ensemble X de R2 est définie par

$$d(x,X) = \inf d(x,y) \text{ avec } y \in X$$

le disque de centre 0 et de rayon ρ, soit D(0,ρ) se note ρD.

4

Le dilaté d'un ensemble X par l'ensemble RD est tel que

$$X \oplus \rho D = \{ x \in R2 \mid d(x,X) \leqslant \rho$$

de même l'érodé peut être défini tel que

$$X \ominus \rho D = \{ x \in R2 \mid d(x,\rho) \subset X \}$$

d) propriétés

On peut établir que le dilaté de A par B est identique à l'ensemble complémentaire, de l'érodé du complément de A par B soit

$$A \oplus B = (A^c \ominus B)^c$$

Toutes ces transformations par tout ou rien sont itératives. On peut alors définir deux autres opérations.

L'ouverture : c'est l'érosion suivie d'une dilatation soit $(A \ominus B) \oplus B$ et

La fermeture : c'est la dilatation suivie d'une érosion soit $(A \oplus B) \ominus B$

Ces deux dernières transformations seront utilisées pour le nettoyage des images.

D'une manière générale, l'érosion supprime de l'image les parties isolées plus petites que l'élément structurant (il en est donc de même pour la dilatation sur $A^c$).

L'ouverture supprime de A toutes les parties plus petites que l'élément structurant sans changer le restant de l'image (la fermeture a un effet identique sur $A^c$).

II. Procédé de traitement numérique de l'image :

Description des différentes étapes de traitement

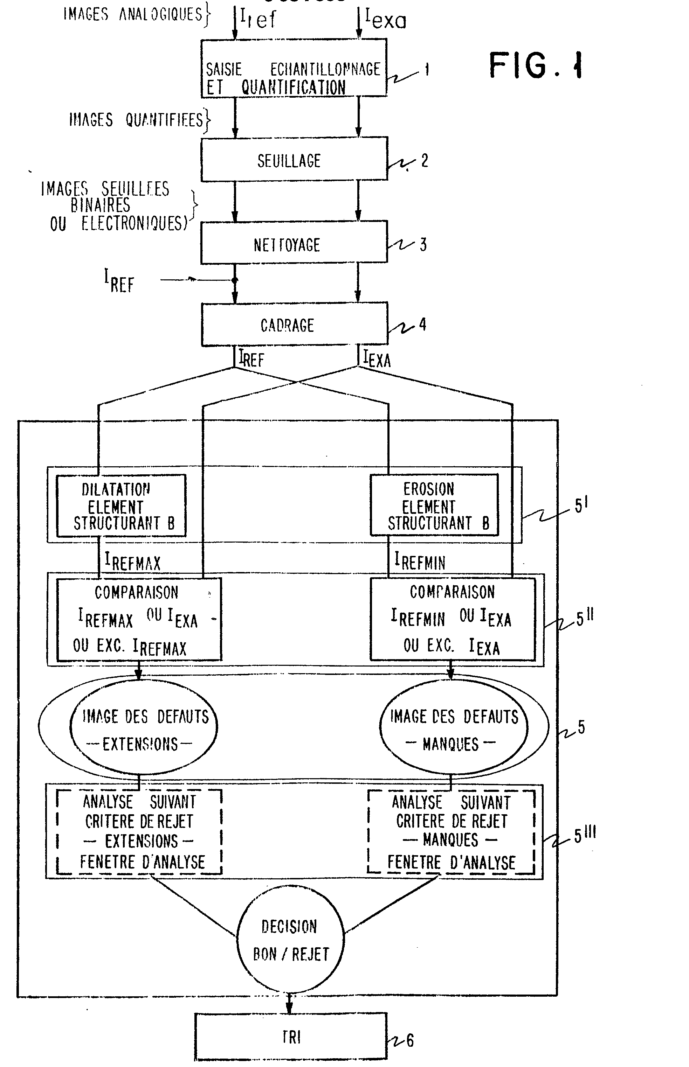

Les différentes étapes de base décrites ci-dessous sont représentées sur l'organigramme de la figure 1 et portent les références 1 à 6.

1. Saisie de l'image, échantillonnage et quantification

Les images de l'objet de référence ($I_{ref}$) et de l'objet à examiner ($I_{exa}$) fournies par le capteur sont par exemple en noir et blanc avec tous les niveaux de gris. Ces images analogiques sont d'abord échantillonnées, selon une trame hexagonale ou carrée par exemple. L'amplitude du signal est quantifiée en chaque point de l'image et cette information est codée sur quatre bits. Les lignes images peuvent comporter un nombre de bits variable selon les applications : En général 1 024 ou 2 048 lignes de 512 à 2 048 bits constituent des nombres satisfaisants pour la majorité d'entre elles. Dans la présente application on choisit 2 048 lignes de 2 048 bits chacune, soit avec un module de 2,54 × 2,54 cm un pas de 12,5 μ entre deux points images (pixels), soit environ 4 millions de points à traiter.

2. Le seuillage

Pour le traitement automatique des défauts, seule compte la géométrie des motifs de l'objet. C'est pour cela que l'on traite des images binaires, obtenues après seuillage.

Tout point de l'image présentant un niveau de gris supérieur à un certain seuil sera égalé à 1, sinon à 0. Cette étape permet d'obtenir des images binaires en noir et blanc. Le problème sera de détecter le bon seuil, pour les objets que l'on veut analyser.

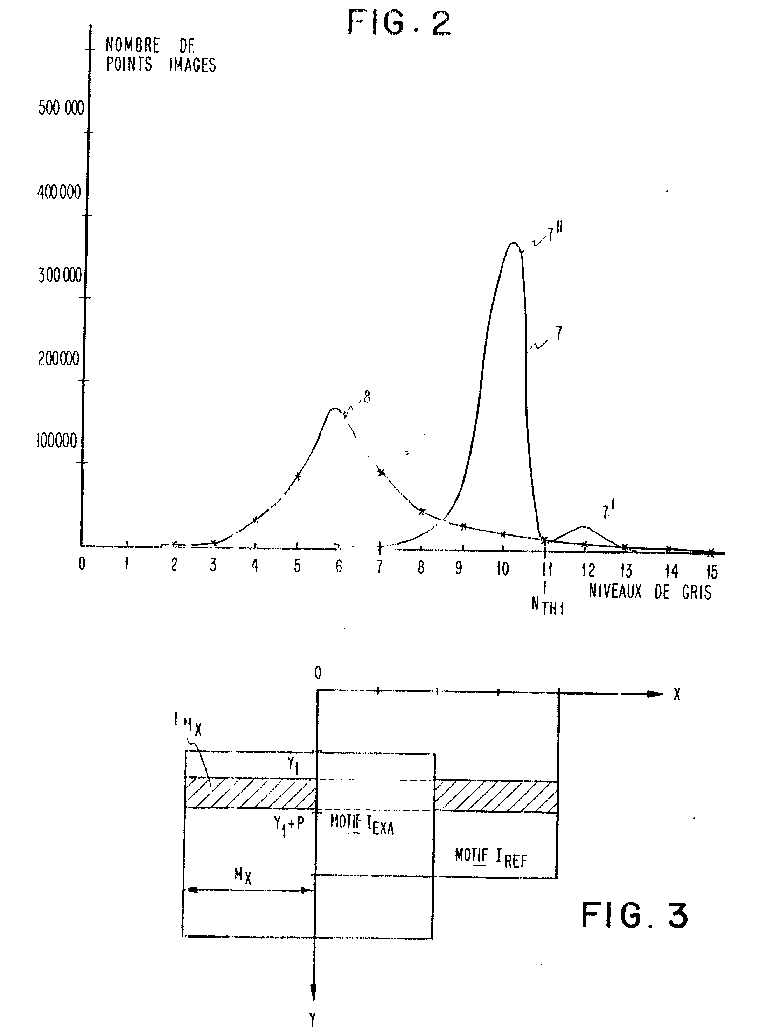

Une technique de seuillage appropriée basée sur l'établissement de l'histogramme des images est décrite ci-après à l'aide de la figure 2. Pour des images discrétisées (16 niveaux de gris) et bien contrastées, les histogrammes présentent deux pics ou modes bien différentiés (7' et 7''), qui sont représentés sur la courbe 7 de la figure 2. Le pic 7' représente la distribution des motifs de l'objet, tandis que le pic 7'' représente la distribution du fond de l'image. Pour détecter le bon seuil il suffit de choisir la valeur $N_{TH}$ du seuil correspondant à la vallée entre les deux pics. En ce qui concerne l'exemple de la courbe 7, on trouve $N_{TH} \# 11$. Ainsi, tous les points de l'image analysée présentant un niveau de gris supérieur à 11, se verront attribuer la valeur binaire 1, tous les autres points se verront attribuer la valeur binaire 0.

Quand le contraste diminue (en d'autres termes l'image présente un gradient de gris pour le fond) la vallée qui sépare les deux pics devient moins sensible et il devient alors difficile de choisir le seuil optimal. Ainsi pour les images présentant peu ou pas de contraste, le choix du seuil peut se faire de différentes façons, notamment en traitant les images par région. On détecte le seuil de chaque région à partir de son histogramme. L'image seuillée résultante est alors la composition de toutes les régions seuillées. Un exemple d'histogramme caractéristique d'une telle image peu contrastée est donné par la courbe 8 de la figure 2. Dans ce cas l'expérience montre que la valeur du seuil $N_{TH}$ peut être choisie égale à 7. Dans tous les cas on peut faire automatiquement par programme une détection automatique du seuil par l'analyse de l'histogramme des intensités des points images de l'image analysée.

Différentes techniques y compris celles mentionnées ci-dessus, pourront être trouvées dans la publication suivante : A Survey of Edge Detection Techniques, par Larry Davis, publié dans Computer Graphics and Image Processing (1975), 4, pages 248-270 et plus particulièrement dans la référence à l'article de C. K. Chow.

### 3. Le nettoyage

Le nettoyage s'effectue par une érosion qui supprime tous les points images relatifs au bruit. La taille de l'élément structurant qui va éroder l'image doit être inférieure à la taille du plus petit défaut que l'on doit détecter. Les parties isolées plus petites que la taille d'érosion disparaissent tandis que les autres restent et seront ultérieurement reconstituées par une dilatation de même taille. Globalement, cette opération constitue une ouverture, on aurait pu aboutir au même résultat par une fermeture ou mieux encore par une combinaison des deux. L'opération de dilatation, s'effectue de façon symétrique : on érode l'image complémentaire de la trame et on prend le complément du résultat, selon la relation explicitée ci-dessous.

$$A \oplus B = (A^c \ominus B)^c$$

Le nettoyage peut être également opéré après l'étape de cadrage. Enfin cette étape peut être facultative selon la qualité des images.

Pratiquement pour ces opérations de la morphologie mathématique : érosion, dilatation, on a le choix entre différents éléments structurants, notamment selon la trame utilisée. Sur l'image échantillonée suivant la trame hexagonale on peut choisir l'hexagone, qui est l'élément structurant le plus proche du cercle. Un hexagone de taille n, où le produit du pas d'échantillonage par n, représentera le rayon du cercle. Dans ce cas, pour l'opération d'érosion de taille 1 par exemple, tous les points de l'image sont scrutés par l'élément structurant qui sera un hexagone de taille 1. Tous les sommets de l'hexagone ainsi que son centre sont égalés à 1. On centre l'hexagone sur le point à analyser. Si le voisinage hexagonal de chaque point ainsi que le point lui-même coïncide avec les valeurs données à tous les sommets de l'hexagone (centre compris), alors le point initial prend la valeur binaire 1, dans le cas contraire il prend la valeur binaire 0. En d'autres termes, on supprime donc de l'image tout point binaire égal à 1 qui a au moins un voisin égal à 0, tandis que les points binaires égaux à 0 gardent leur valeur : l'image a donc subi une transformation du type par tout ou rien.

Si une trame carrée est utilisée on pourra utiliser un élément structurant en forme de croix et on procédera de même. La taille et le motif de l'élément structurant peuvent varier selon le type d'application. Dans la présente description, la trame carrée et un élément structurant simple en forme de croix, seront seuls utilisés aux fins de la simplicité de l'exposé. Le nombre de points images (pixels) varie de 500 000 à 10 millions et plus selon les applications.

### 4. Le cadrage

Avant de comparer l'image de référence avec l'image échantillon, il est nécessaire de recadrer les deux images dans l'espace. Cette opération qui doit être automatique peut se faire par programme. Différentes techniques qui sont connues de l'homme de l'art, notamment pour le cadrage ou l'alignement des masques, (par exemple à l'aide de marqueurs ou repères) peuvent être utilisées. Une technique de recadrage donnant satisfaction est explicitée ci-après à l'aide de la figure 3.

Sur la figure 3, on a représenté schématiquement deux motifs, l'un appartenant à l'image de l'objet de référence $I_{REF}$ et l'autre à l'image de l'objet échantillon, $I_{EXA}$, ce dernier motif est désaligné par rapport à celui de l'image de référence. Ces motifs peuvent être des portions de marqueurs ou repères qui sont utilisés couramment pour l'alignement des masques, des modules, etc.

Le programme permet de calculer le décalage entre les deux images, en x et en y.

Pour calculer ce décalage en x, qui est représenté par $M_x$, il suffit de prendre quelques lignes y successives (à partir d'une ligne déterminée $y_1$) qui traversent les deux images et de calculer la surface hachurée $I(M_x)$. On s'aperçoit sur la figure 3 que plus on décale $I_{ECH}$ vers la droite (par incrément sur l'axe des x), plus cette surface $I_{(Mx)}$ diminue. Elle tend vers un minimum quand on atteint le recadrage optimal en x.

Pour que le calcul soit plus rapide, le programme ne traite qu'un groupe limité p de lignes pour le décalage en x, et de q colonnes pour le décalage en y.

Le choix des paramètres ($y_1$ et p, en ce qui concerne le décalage en x), se fait à l'entrée du programme. Ce programme consiste donc à analyser la fonction $I(M_x)$ qui représente la surface hachurée, selon les différentes valeurs des $M_x$ (décalage en x entre les deux images).

Il détermine alors automatiquement la valeur $M_x$, à un minimum de la fonction $I(M_x)$.

On opère de la même façon pour le décalage en y en prenant des lignes verticales parallèles à l'axe Oy, ce qui conduit à la détermination de $l(M_y)$ et $M_y$ à l'aide des paramètres correspondants $(x_1, q)$.

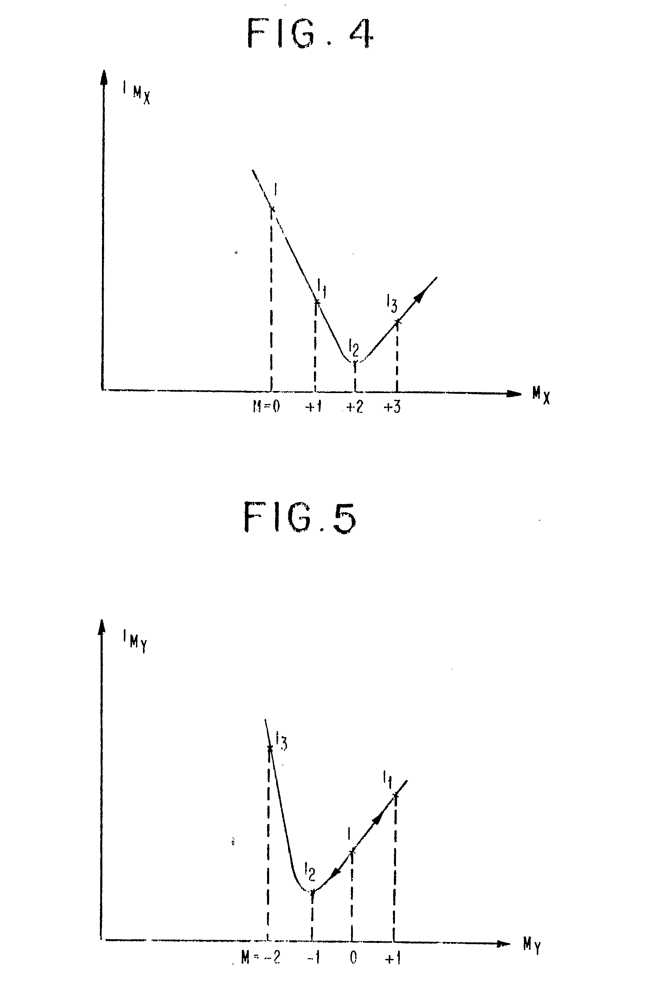

En prenant comme exemple la configuration montrée sur la figure 3, le résultat de ces opérations logiques prend la forme des courbes montrées sur les figures 4 et 5. Sur ces figures on a représenté, $l(M_x)$ et $l(M_y)$ qui mettent en évidence les minima pour certaines valeurs de M. Sur la figure 4 on voit que la fonction $l(M_x)$ décroît à partir de la valeur initiale $l$ en prenant les valeurs $l_1$, $l_2$, avant de croître et prendre la valeur $l_3$, (pour des valeurs $y_1$ et $p$ déterminées) pour différentes valeurs de $M_x$, quand on a décalé $l_{EXA}$ par incréments successifs vers la droite. Le minimum de $l(M_x)$ est obtenu pour deux incréments. Il faut donc déplacer $l_{EXA}$ de deux incréments vers la droite.

De façon similaire, $l(M_y)$ est représentée sur la figure 6. Cette figure montre qu'une première tentative ($l_1$) vers la droite est dans la mauvaise direction puisque $l_1 > l$, puis vers la gauche, le minimum est donc obtenu pour un incrément vers les y négatifs.

Cette étape de recadrage peut être aisément effectuée à l'aide d'un programme informatique.

Il faut comprendre que dans certaines applications le recadrage peut se faire soit dans le plan $(x, y, \ominus)$ soit même dans l'espace $(x, y, z)$.

En ne choisissant qu'une partie de l'image, il faut cependant s'assurer que ces lignes traversent bien les motifs de l'objet analysé tant pour l'échantillon que pour la référence, et non pas le fond uniquement. Le choix se fait simplement à partir de l'image de référence que l'on connaît au départ et qui permet la détermination de ces paramètres $(x_1, y_1, p, q, ...)$. De plus si l'on veut que les résultats du calcul du décalage ait une réalité physique il faut que chaque motif de $l_{ref}$ chevauche le motif correspondant de $l_{exa}$. Ceci peut être assuré par un cadrage grossier effectué lors de la saisie d'images. Après avoir successivement saisies, échantillonnées, quantifiées, seuillées, nettoyées et cadrées, les images binaires obtenues sont notées $l_{REF}$, pour l'image résultante de l'objet de référence et $l_{EXA}$ pour l'image résultante de l'objet à examiner.

### 5. Mise en évidence des défauts

Dans l'industrie des circuits intégrés à semi-conducteurs, on a vu que les objets à comparer sont essentiellement des masques (réticules), des microplaquettes de circuits intégrés, et des modules électroniques. Dans tous les cas, il existe des tolérances dimentionnelles pour certains motifs de ces objets par exemple en ce qui concerne les modules, la largeur des lignes conductrices.

La topologie d'un module typique 9 est représentée sur la figure 6. Il s'agit d'un substrat de céramique sur lequel on a formé une configuration de lignes conductrices 10 qui assurent la liaison électrique entre les plots d'une microplaquette disposée à l'emplacement 11 et des broches (non représentées) disposées aux emplacements des trous 12. Les lignes conductrices sont élargies aux emplacements des broches, pour former des pattes de contact 13. Les lignes conductrices et les pattes de contact présentent des dimensions uniformes sur toute la surface du substrat comme cela apparaît sur la figure.

Les tolérances dimensionnelles de ces lignes conductrices sont connues et spécifiées dans des instructions de fabrication et de contrôle et varient naturellement selon la nature des objets à analyser.

Certaines sont fixes sur tout l'objet à analyser (c'est le cas du module représenté sur la figure 6), d'autres sont variables selon l'emplacement des motifs sur l'objet (cas de certains modules). Par ailleurs on a noté qu'il y avait deux grands genres de défauts avec les modules, 1) les manques : ce qui manque à l'image du module à examiner par rapport à l'image du module de référence, et 2) les extensions : ce qui a été ajouté à l'image du module à examiner par rapport à l'image du module de référence.

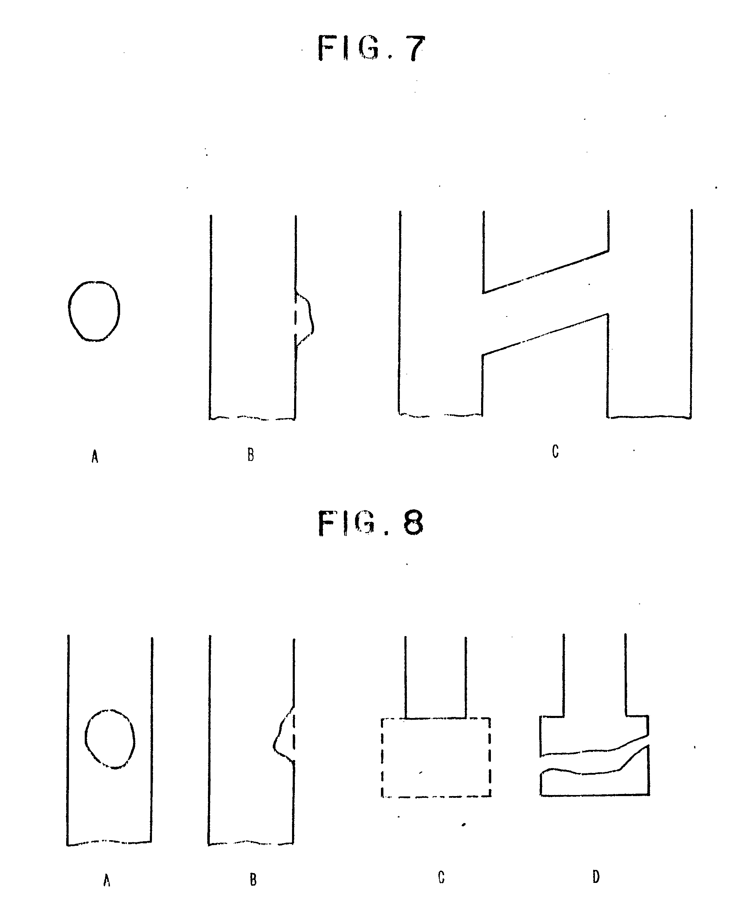

Dans ce domaine, les défauts peuvent prendre diverses formes dont certaines, parmi les plus caractéristiques sont montrées sur les figures 7 et 8.

1) Cas d'une extension

Les défauts peuvent être de trois types :

A) îlot (motif parasite)
B) excroissance le long d'un motif
C) pont (entre deux motifs)

ces défauts sont respectivement montrés sur la figure 7, parties A, B et C.

2) Cas d'un manque

Les défauts peuvent être de quatre types :

A) trou, dans un motif
B) échancrure
C) absence totale du motif
D) rupture dans le motif ces défauts sont respectivement représentés sur la figure 8, parties A, B, C et D.

Dans la présente demande, on ne s'appliquera à considérer que des objets qui présentent des tolérances constantes, c'est le cas du module représenté sur la figure 6. Dans ces conditions relativement simples, il n'y aura donc que deux critères de rejets qui seront appliqués : relatifs aux défauts du genre « manque » et aux défauts du genre « extension ». On dressera, une carte ou image des défauts pour chaque genre de défaut, grâce à un traitement différent des images $I_{REF}$ et $I_{EXA}$ à comparer.

Pour déterminer les défauts du genre « extension » en tenant compte de la largeur maximale tolérée, on dilate $I_{REF}$ de la taille des tolérances dimensionnelles, ce qui donne $(I_{REF})_{max}$, puis on compare avec $I_{EXA}$ en faisant l'opération logique complexe

$$[(I_{REF})_{max} \text{ OU } I_{EXA}] \text{ OU EXCLUSIF } (I_{REF})_{max}.$$

Si l'ensemble résultant ou image des défauts n'est pas vide, c'est qu'il y a des défauts du genre « extension ». Cette opération logique est retenue parce qu'elle permet la sélection des défauts du genre « extension » uniquement. Pour les défauts du genre « manque » on érode $I_{REF}$ de la taille des tolérances dimensionnelles ce qui donne $(I_{REF})_{min}$ puis on compare avec $I_{EXA}$ en faisant selon l'opération logique complexe

$$[(I_{REF})_{min} \text{ OU } I_{EXA}] \text{ OU EXCLUSIF } I_{EXA}.$$

Si l'ensemble résultant ou image de défauts n'est pas vide c'est qu'il existe des défauts du genre « manque ». Cette opération logique est retenue parce qu'elle permet la sélection des défauts du type manque uniquement. On remarquera que dans le présent mode de réalisation l'élément structurant B des opérations de dilatation et d'érosion sera identique pour les deux opérations, car les tailles des tolérances dimensionnelles minimales et maximales sont égales. Dans le cas où elles seraient différentes, des éléments structurant de tailles différentes seraient utilisés.

D'autres opérations logiques peuvent être envisagées, notamment si une seule image de défauts est souhaitée. On obtient donc finalement (voir figure 1) deux images des défauts l'une mettant en évidence les « extensions », l'autre les défauts du genre « manque ».

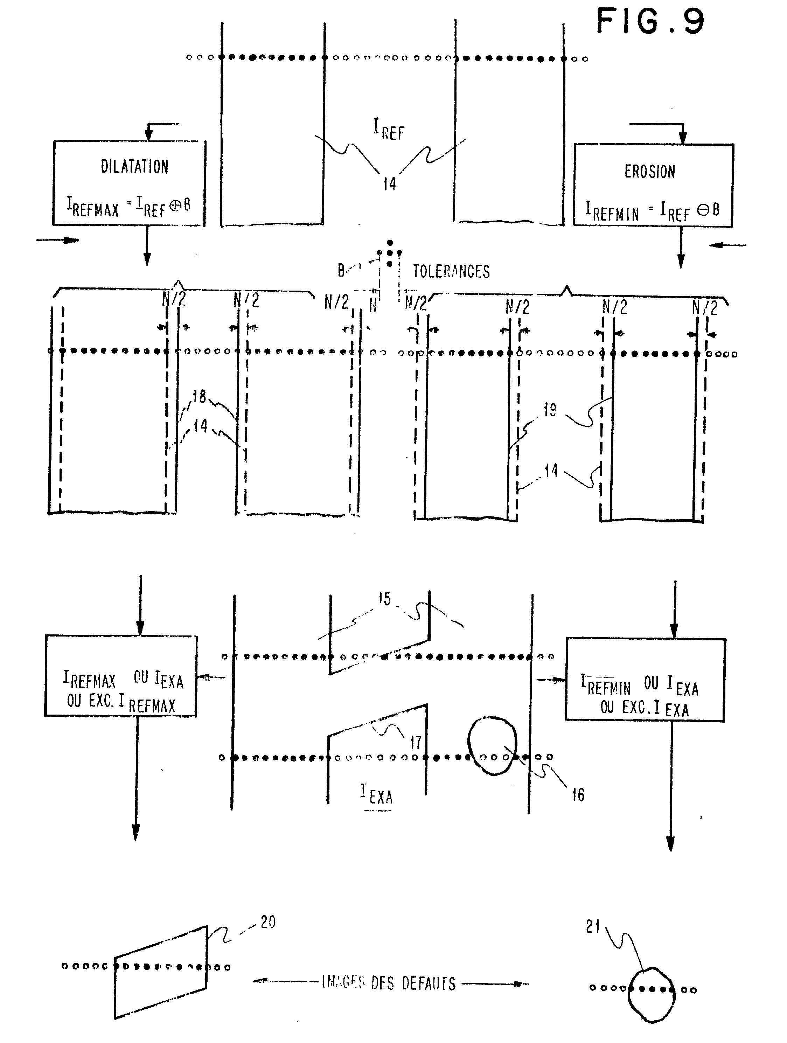

On va expliciter plus simplement cette étape 5 de mise en évidence des défauts à l'aide de la figure 9. Sur cette figure, on a représenté une image de référence $I_{REF}$ qui représente par exemple une portion 14 de deux lignes conductrices 10 du module 9 représenté sur la figure 6. On a représenté également l'image $I_{EXA}$ du module à examiner avec les deux conducteurs correspondants 15 mais qui présente par rapport à $I_{REF}$ à la fois un manque (trou) 16 et une extension (pont) 17, c'est-à-dire un défaut de chaque genre. Comme il s'agit d'images numériques, les pixels ont été représentés par des petits cercles. Les cercles pleins montrent les points images effectifs qui correspondent donc à des « 1 » binaires. On forme d'abord les images $(I_{REF})_{max}$ et $(I_{REF})_{min}$, qui sont respectivement le dilaté et l'érodé de l'image de référence par un même élément structurant B, dont la taille correspond dans ce cas aux tolérances dimensionnelles maximales et minimales ± N admises pour ces lignes. Dans l'exemple montré de la figure 9, on a choisi $N/2 = 12,5\ \mu$, pas ou intervalle entre deux pixels. L'élément structurant présente la forme rudimentaire d'une croix symétrique. Après le traitement les lignes sont respectivement référencées 18 et 19.

L'opération suivante consiste donc à faire la comparaison selon des opérateurs logiques complexes. On forme d'abord

$$[(I_{REF})_{max} \text{ OU } I_{EXA}] \text{ OU EXCLUSIF } (I_{REF})_{max}$$

ce qui fait apparaître le défaut 20 du type pont et ensuite

$$[(I_{REF})_{min} \text{ OU } I_{EXA}] \text{ OU EXCLUSIF } I_{EXA}$$

ce qui fait apparaître le défaut 21 de type trou.

On remarque que l'on peut combiner les deux images de défaut sur une image unique à l'aide d'une opération OU.

On remarque également que l'on aurait pu comparer $I_{REF}$ et $I_{EXA}$ au cours d'une opération préliminaire, l'absence de défauts aurait signifié que l'objet à examiner était identique à l'objet de référence.

La dernière opération de l'étape 5, consiste à analyser les images de défauts selon des critères de rejet qui leur sont propres. Ces critères dans le cas d'objets présentant des tolérances dimensionnelles constantes, consistent simplement dans les dimensions de défauts acceptables. Pratiquement cela revient à générer une fenêtre d'analyse, et à comparer chaque défaut avec cette fenêtre. La forme, la situation, la nature des défauts ne sont pas prises en considération. Les critères de rejet dans ce cas sont donc très rudimentaires et peuvent être identiques à la fois pour le manque et l'extension.

Ainsi l'étape de traitement 5 comporte essentiellement une première opération 5' d'ajustement de la configuration de $I_{REF}$ aux tolérances dimensionnelles (dilatation et érosion), une seconde opération 5'' de comparaison avec $I_{EXA}$, qui fournit deux images des défauts (genre « manque » et genre « exten-

**0 054 598**

sion ») et enfin une troisième opération 5‴ d'analyse des images des défauts selon des critères de rejet préalablement déterminés.

Les modules sont donc analysés très rapidement. Dans la fabrication des modules, les modules qui présentent des défauts sont relativement peu nombreux, par exemple ils sont inférieurs à 5 %. Les modules qui présentent des défauts et qui sont rejetés à ce niveau, peuvent être examinés ou ré-examinés plus en détail par une étape supplémentaire de reconnaissance et d'analyse des défauts.

Certains défauts en effet, peuvent être acceptés dans la mesure où on considère qu'ils ne nuisent pas à la fiabilité du module. Cette étape supplémentaire très importante en raison du coût élevé des modules, fait l'objet de la demande de brevet européen conjointe EP-0 054 596 déposée le 18 décembre 1980 par la demanderesse.

### 6. Le tri

Les objets jugés bons, c'est-à-dire présentant des images de défauts vierges où dont les défauts sont acceptables au vu des critères de rejet, sont acceptés à ce niveau.

### III. Equipement de mise en œuvre

Le procédé de traitement numérique des images de l'objet de référence et de l'objet à examiner tel qu'il est décrit dans la partie II de la présente demande, peut trouver application dans des domaines très divers comme on l'a écrit ci-dessus et en particulier dans l'industrie des semi-conducteurs, où il peut être notamment utilisé pour le tri automatique des circuits imprimés, des modules, des masques et des microplaquettes semi-conductrices (contrôle de la métallurgie), dont certains motifs, tels que les lignes conductrices présentent des tolérances dimensionnelles fixes. En ce qui concerne les masques, et les modules, les images sont très contrastées (pratiquement noires et blanches), dans ce cas la détection automatique du seuil peut se faire sans difficulté ainsi que le recadrage.

### Premier mode de réalisation

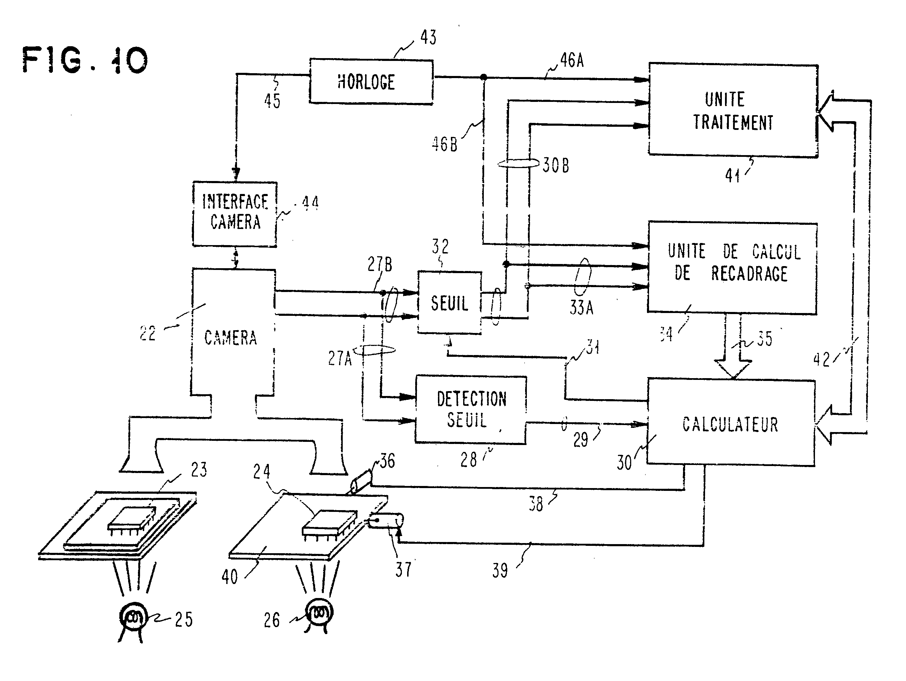

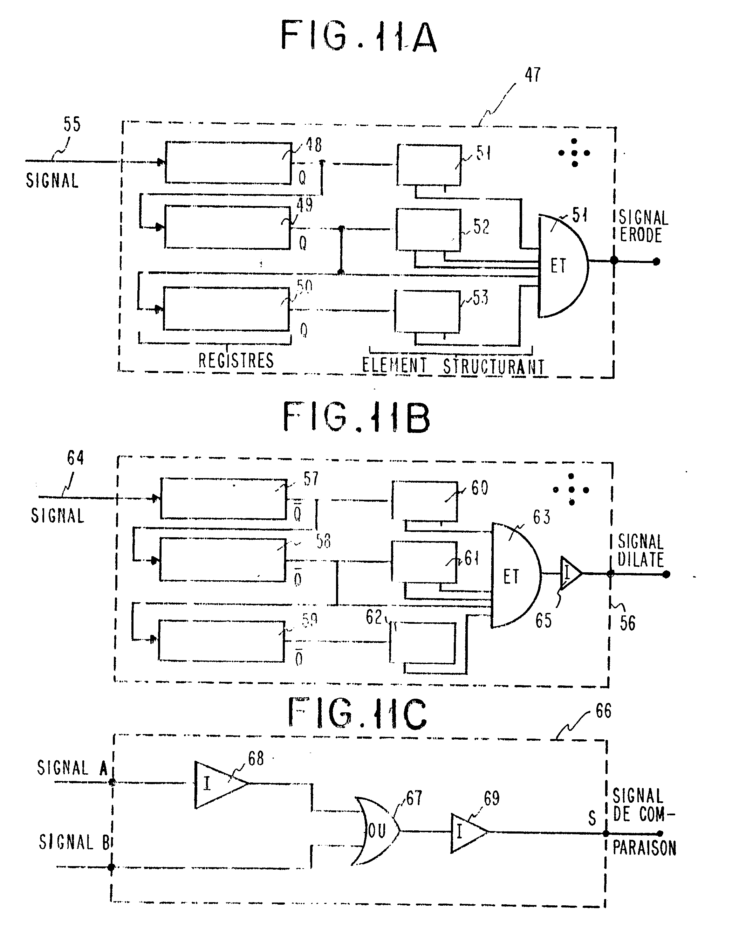

Un exemple d'équipement approprié va être décrit ci-dessous, par référence à la figure 10.

Différents types de capteurs peuvent être utilisés selon la nature des objets à trier. Un microscope électronique peut s'avérer indispensable pour les microplaquettes et les masques (1X). Une simple caméra ou un réseau de photodiodes, ou à charges couplées, peut suffire pour les réticules (10X), ou les modules. C'est cette dernière application qui a été retenue dans la présente description. Un module typique de 2,5 × 2,5 cm présente une configuration de lignes conductrices d'une largeur constante égale à 125 microns avec une tolérance N de 25 microns. Cela veut dire qu'une ligne conductrice est acceptée dès lors que sa largeur L vérifie la relation $100\,\mu \leqslant L \leqslant 150\,\mu$. Avec une caméra de 2 Kbits, la distance entre deux pixels est d'environ 12,5 microns. L'élément structurant B de la figure 9 correspondra parfaitement puisque la tolérance N est également de 25 microns. Pour des modules qui présentent une largeur de conducteur supérieure à $125\,\mu$, par exemple $250\,\mu$, on prendre le multiple le plus approprié de $25\,\mu$. Dans tous les cas, on peut choisir une caméra qui a la résolution la plus appropriée.

Une caméra couleur digitale 22 de résolution 10 bits (tube vidicon) constitue le capteur. L'objet de référence 23 et l'objet à examiner 24 sont éclairés par deux sources de couleur différentes (rouge et bleue) 25 et 26, deux objectifs forment les deux images à comparer tandis qu'un jeu de prismes (non représenté) les superpose sur l'objectif de la caméra. Les deux images sont donc captées au même moment, par la caméra couleur qui se charge de séparer les deux signaux de couleurs différentes à la sortie.

Ce dispositif a l'avantage de conserver les 10 bits de résolution, en s'affranchissant des dérivés thermiques de la caméra, des imperfections du tube vidicon ainsi que des aberrations optiques.

Après avoir été séparés, les signaux digitaux issus de la caméra sont transmis par le bus 27A à un bloc de détection de seuil 28, où ils sont analysés. Ce bloc 28 établit les histogrammes en intensités des deux images (répartition des gris) et les fournit par le bus 29 au calculateur 30, ce dernier détermine les seuils respectifs des images $I_{ref}$ et $I_{exa}$. Ces valeurs sont alors affichées par le bus 31 à l'entrée du bloc de seuil 32 qui reçoit également les signaux émis par la caméra par le bus 27B. A la sortie de ce bloc 32, les images sont seuillées : chaque point image prend la valeur binaire 0 ou 1, après avoir été comparé au seuil. Les deux images binaires seuillées sont envoyées par le bus 33A à l'unité de recadrage 34 (en x, y et éventuellement θ). Avec le procédé choisi décrit ci-dessus (II.4) cette unité calcule les surfaces I(M) de l'aire de non-recouvrement des deux images lorsqu'elles sont décalées. Les informations sont transmises par le bus 35 au calculateur 30. Le calculateur commande les moteurs pas-à-pas 36 et 37 par les lignes 38 et 39, qui déplacent le support 40 de l'objet à examiner, en analysant les résultats du bloc de recadrage, jusqu'à obtenir le recadrage optimum, qui correspond comme on l'a vu plus haut, au minimum des fonctions I(M) (en x et en y).

Pour que le calcul soit plus rapide, le programme ne choisit qu'un groupe de huit lignes pour le décalage en x (p = 8) et huit colonnes pour le décalage en y (q = 8).

L'unité de traitement 41 reçoit alors par le bus 30B, des informations qui correspondent à des images parfaitement cadrées.

9

Cette unité assure les différentes opérations logiques mentionnées ci-dessus, qui sont précâblées.

Schématiquement cette unité se compose de deux ensembles : un premier ensemble qui analyse les manques, un autre qui analyse les extensions.

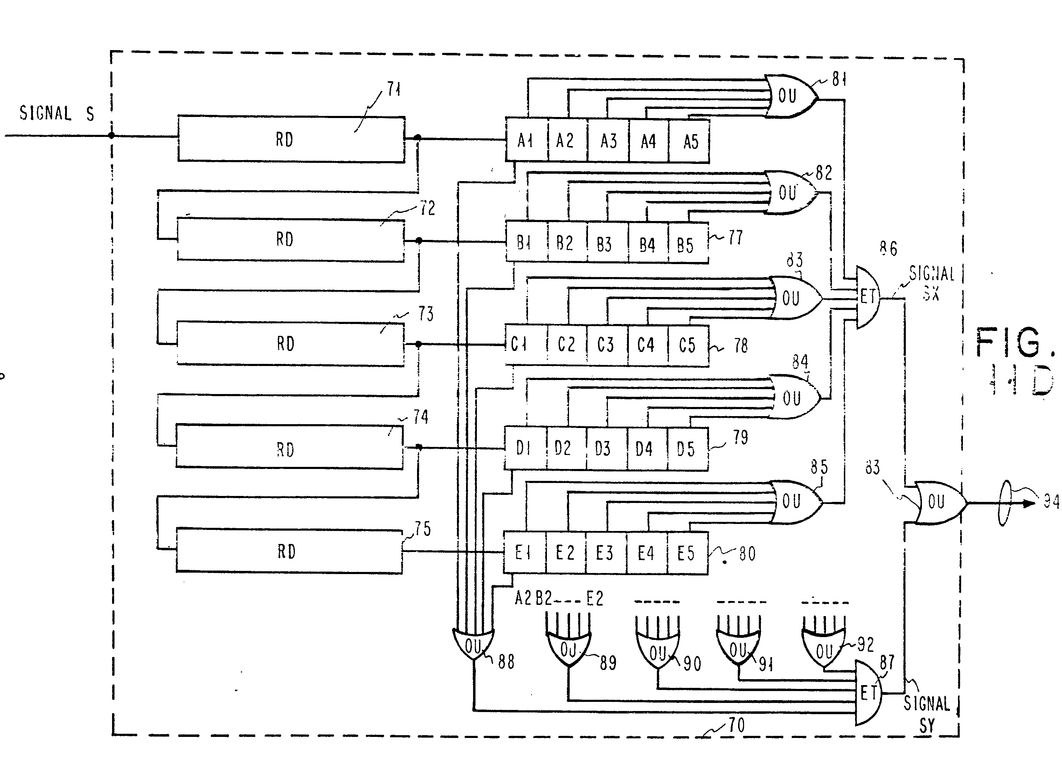

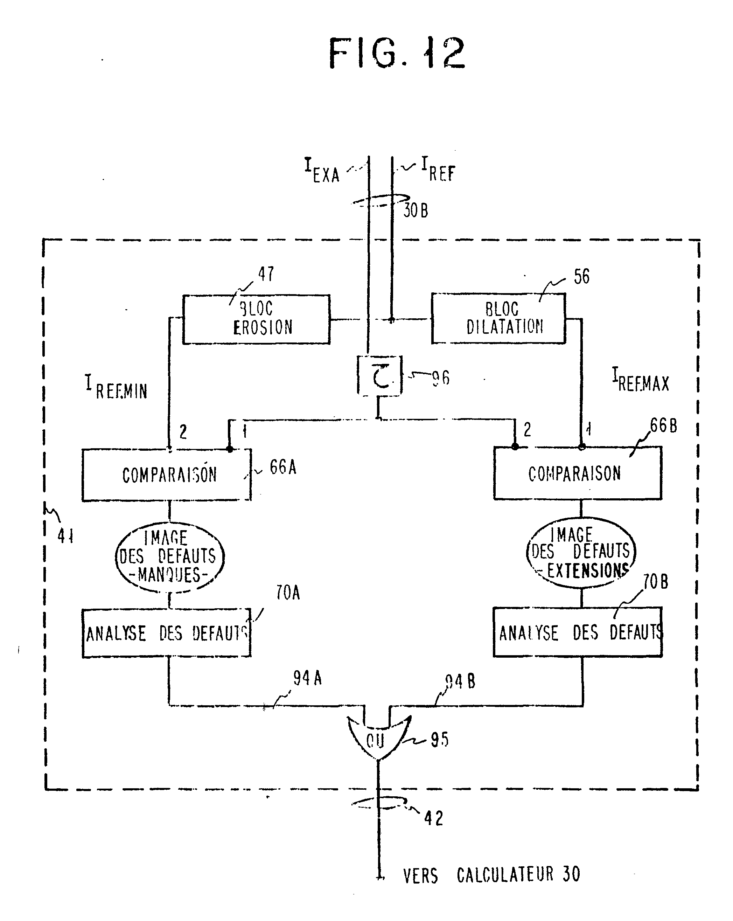

En outre elle mesure les projections horizontales et verticales du défaut et sa position. Elle contient les blocs érosion et dilatation. Cette unité analyse et compare les images selon le procédé décrit sur la figure 1 et transmet au calculateur 30 par une ligne du bus 42 le résultat : l'objet à examiner est « bon » ou est « à rejeter ». L'ensemble est piloté par une horloge 43 (par exemple 10 MHz) qui commande le circuit d'interface 44 de la caméra, l'unité de traitement 41 et l'unité de calcul de recadrage 34 respectivement par les lignes 45 et 46 A et B. Les circuits composant l'unité de traitement 41 sont plus particulièrement détaillés sur les figures 11A à 11D. Le bloc diagramme de l'unité de traitement est représenté sur la figure 12.

Sur la figure 11A on a représenté le bloc érosion 47 qui comporte essentiellement trois parties : une partie mémorisation constituée par des registres à décalage munis de deux sorties Q et $\bar{Q}$. Une partie assurant la fonction de génération de l'élément structurant B montré sur la figure 9 et une porte ET. Le nombre de registres est fonction du nombre de lignes qu'il convient de mémoriser. Dans l'exemple de l'élément structurant en forme de croix, mentionné ci-dessus, il faut mémoriser trois lignes, on a donc introduit trois registres à décalage 48, 49 et 50. La capacité de ces registres dépend évidemment du nombre de bits représentatifs de la ligne : 1 024 ou 2 048 bits par exemple. Compte tenu de l'élément structurant en forme de croix choisi, trois registres à décalage à 2 bits, 51, 52 et 53 sont donc nécessaires. Ces derniers registres sont du type à sortie parallèle c'est-à-dire que les bits sont accessibles directement dans le registre. On utilise les deux sorties du registre 52 puisque l'on doit comparer trois points (branche horizontale de la croix y compris le centre) alors qu'une seule sortie est nécessaire pour chaque registre 51 et 53 qui comparent chacun seulement un point (branche verticale de la croix excepté le point central déjà compté dans la branche horizontale). Enfin le bloc érosion comporte une porte ET 54. Le fonctionnement est le suivant. Le signal binaire d'entrée représentatif de l'image de l'objet de référence $I_{REF}$, arrive dans le bloc érosion par la ligne 55. Les données binaires remplissent le premier registre 48, puis ligne par ligne, les autres registres. Les registres 51, 52, et 53 de l'élément structurant agissent à tout moment comme une fenêtre. Le circuit ET 54 ne fournira un 1 à la sortie que pour les points correspondants à $(I_{REF})_{min}$. En effet, pour ces points et ces points seulement, les sorties Q des registres 48, 49 et 50 d'une part et le contenu utile des registres 51, 52 et 53 seront au niveau 1 (1 représente la présence d'un point image). On trouve donc à la sortie du bloc 47, le signal d'entrée érodé. Il est évident que selon le nombre et la nature des registres tels que 51, 52 et 53 et le câblage de la porte ET, on peut obtenir des éléments structurants de formes diverses (hexagone sur une trame hexagonale, carré ou croix sur une trame carrée, ...). Ce bloc assure donc l'élaboration de $(I_{REF})_{min}$ telle que cette image est représentée sur la figure 9 (conducteurs 19).

Le bloc dilatation 56 montré sur la figure 11B, est similaire au bloc érosion 47, il s'en déduit par la relation mentionnée ci-dessus (voir I.d) dilatation = complément (de l'érodé ou complément de l'image).

On utilise donc cette fois la sortie inverse $\bar{Q}$ de trois registres à décalage 57, 58 et 59 identiques aux registres 48, 49 et 50 et trois registres à décalage à deux bits 60 à 62, le câblage de la porte ET 63 est également identique. A la sortie de la porte ET 63 on obtient donc l'érodé de l'inverse du signal qui apparaît sur la ligne 64 et par l'action du circuit inverseur 65, le signal de sortie est bien le dilaté du signal d'entrée. En appliquant comme signal d'entrée, $I_{REF}$, on obtient à la sortie du bloc 56, le signal $(I_{REF})_{max}$.

Les circuits 47 et 56 peuvent bien sûr être utilisés pour effectuer l'étape de nettoyage 3, il suffit de déterminer l'élément structurant approprié correspondant au plus petit défaut acceptable au niveau des images électroniques, comme cela a été écrit plus haut.

Sur la figure 11C on a représenté un exemple de circuit 65 susceptible de réaliser l'opération (SIGNAL A OU SIGNAL B) OU EXC. SIGNAL B entre les signaux d'entrée SIGNAL A et SIGNAL B, qui est l'opération de principe de la comparaison mentionnée à l'étape 5 de la figure 1. Le circuit 66 comporte un circuit OU 67 qui reçoit d'une part le signal A préalablement inversé dans l'inverseur 68 et le signal B. Le signal résultant est de nouveau inversé dans l'inverseur 69. Le signal de sortie est donc :

$$(\overline{SIGNAL\ A\ OU\ SIGNAL\ B}) = (SIGNAL\ A)\ ET\ (\overline{SIGNAL\ B})$$

cette expression peut également s'écrire :

$$(SIGNAL\ A\ OU\ SIGNAL\ B)\ OU\ EXC.\ (SIGNAL\ B).$$

Si on applique au bloc 66, les signaux représentatifs de $I_{REF\ min}$ et $I_{EXA}$ on trouve le signal représentatif des défauts du genre manque en faisant

$$SIGNAL\ A = I_{REF\ min}\ et\ SIGNAL\ B = I_{EXA}.$$

Dans ce cas le bloc de comparaison 66 sera référence 66A.

De façon similaire le signal représentatif des défauts du genre extension s'obtient en faisant

$$\text{SIGNAL A} = I_{EXA} \text{ et SIGNAL B} = I_{REF\ max}$$

et le bloc de comparaison sera référencé 66B.

Sur la figure 11D on a représenté un circuit 70 capable d'assurer l'opération d'analyse telle qu'elle est mentionnée sur la figure 1 (étape 5). Pour la simplification de l'exposé, on admet que le critère de rejet est le même qu'il s'agisse de défauts du genre « manque » ou du genre « extension ». Dans l'exemple choisi, on admet que le plus petit défaut acceptable aura une projection de quatre pas images (pixels), soit sur l'axe des X soit sur l'axe des Y, par conséquent, le circuit ne détectera un défaut qu'à partir d'une projection de cinq pas. La fenêtre d'analyse dans ce cas a donc pour dimensions 5 × 5 pixels. On mémorisera cinq lignes de signal de l'image des défauts dans les registres à décalage (dont seul le dernier bit est accessible) : 71 à 75, qui attaquent respectivement cinq registres référencés 76 à 80 à cinq positions, chaque position étant accessible. Les positions A1 à A5, B1 à B5, etc. des registres 76, 77 etc. attaquent respectivement des circuits OU 81, 82, etc.. Les sorties de ces circuits OU sont les entrées d'une porte ET 86. Si à un moment donné, il y a au moins une ligne de l'image de défauts qui comporte cinq points images (soit cinq bits « 1 »), le circuit ET 86 passe dans ce cas au niveau « 1 » et indique qu'il y a un défaut qui présente une longueur selon l'axe des X, égale ou supérieure à 5 pixels. L'objet doit donc être rejeté. La même information peut également être obtenue en ce qui concerne l'axe des Y sur la porte ET 87 qui est attaquée par les circuits OU 88 à 92 qui fonctionnent de façon similaire aux circuits OU 81 à 85. Le circuit OU 88 rassemble les positions A1 B1 C1 D1 E1 soit cinq positions selon l'axe des X. Des objets présentant les défauts tels que référencés en 20 et 21 montrés sur la figure 9 seraient donc rejetés avec ce critère, le défaut 20 montre en effet qu'il a une longueur maximum de 11 pixels selon l'axe des X, tandis que le défaut 21 montre 6 pixels selon l'axe des Y. Les signaux SX et SY issus des portes ET 86 et 87 attaquent un circuit OU 93. La présence d'un défaut inacceptable est donc signalée par la ligne 94 quand elle est à un niveau haut, quand un bloc d'analyse de défauts 70 traite les signaux provenant de l'image des défauts du genre manque, il sera référencé 70A (ligne de sortie 94A) et quand il traite les signaux provenant de l'image des défauts du genre extension il sera référencé 70B (ligne de sortie 94B). Enfin on peut remarquer que des fenêtres d'analyse plus complexes peuvent être envisagées par l'homme de métier selon les différentes applications.

Tous les registres montrés sur les lignes 11A à 11D sont évidemment pilotés par l'horloge 43.

Sur la figure 12 on a représenté le schéma synoptique de l'unité de traitement 41 (les interactions avec l'horloge 43 n'ont pas été représentées) qui assure la totalité des opérations figurant dans le bloc 5 de la figure 1 (et éventuellement en plus l'étape de nettoyage du bloc 3). L'unité de traitement est également sous le contrôle du calculateur 30 à qui elle fournit par le bus 42 les éléments de décision quand à l'objet à examiner (étape de tri, bloc 6, figure 1). Les circuits représentés ont été décrits ci-dessus par référence aux figures 11A à 11D. Les résultats fournis par les circuits d'analyse de défauts 70A et 70B, pour respectivement les images des manques et des extensions sont traités par un circuit OU 95 qui fournit les éléments de décision bon/rejet au calculateur 30 par le bus 42. Un circuit à retard (de délai t ajustable) portant la référence 96 est également montré sur la figure 12. Il permet de retarder $I_{EXA}$ pour que cette image soit traitée en phase, dans les circuits de comparaison 70A et 70B, avec $I_{REF\ max}$ et $I_{REF\ min}$ qui ont déjà subis une étape de traitement préalable dans les blocs 47 et 56.

### Deuxième mode de réalisation

Une variante consiste à ne traiter par les étapes mentionnées ci-dessus : saisie et échantillonnage (1), seuillage (2), nettoyage (3), et cadrage (4), que l'image de l'objet à examiner. L'image de l'objet de référence a été mise en mémoire dans le calculateur une fois pour toute. Le calculateur peut avoir en mémoire, un grand nombre d'images électroniques d'objets de référence différents par exemple des modules présentant des topologies différentes correspondant à des numéros de pièces différents, ou encore des masques. Dans cette dernière application les données binaires correspondant aux images peuvent être celles fournies directement par les générateurs de configurations de type Gerber. Les images électroniques de l'objet de référence et de l'objet à examiner peuvent être cadrées à partir de marqueurs disposés sur les objets. Cette technique est connue tant pour les masques que pour les microplaquettes, où les problèmes d'alignement sont essentiels. On aboutit ainsi à des images $I_{REF}$ électroniques stockées en mémoire qui peuvent être appelées par le calculateur pour être traitées dans l'unité de traitement de la façon mentionnée ci-dessus. Des mémoires à bulle (ou des disques) peuvent être utilisées en raison du grand nombre de bits à mémoriser (par exemple 4 mégabits) ce qui correspond à une matrice de pixels de 2 048 × 2 048 bits, chiffre qui apparaît suffisant pour le tri des masques (réticules 10X) et des modules.

## Revendications

1. Procédé d'inspection et de tri automatique d'objets à examiner présentant des configurations ayant des tolérances dimensionnelles fixes pour l'application particulière visée du genre comportant la comparaison de l'image $I_{ref}$ d'un objet de référence et de l'image $I_{exa}$ d'un objet à examiner, ce dernier étant susceptible de présenter des défauts géométriques par rapport à l'objet de référence, ledit procédé comprenant l'étape :

1) d'élaboration des images $I_{ref}$ et $I_{exa}$ sous forme d'images électroniques binaires référencées respectivement par $I_{REF}$ et $I_{EXA}$,

et étant caractérisé en ce qu'il comporte en outre les étapes suivantes :

2) définition d'un élément structurant, dit élément structurant de tolérance, directement lié aux tolérances dimensionnelles et formation des images $I_{REF\ max}$ et $I_{REF\ min}$ qui sont respectivement l'image électronique binaire $I_{REF}$ dilatée et érodée par ledit élément structurant de tolérance,

3) formation des images des défauts du genre extension ou du genre manque en réalisant respectivement les opérations logiques

$$[I_{REF\ max}\ OU\ I_{EXA}]\ OU\ EXC.\ I_{REF\ max}\ et$$

$$[I_{REF\ min}\ OU\ I_{EXA}]\ OU\ EXC.\ I_{EXA}\ et$$

4) tri des objets à examiner pour sélectionner ceux présentant des images de défauts vierges.

2. Procédé d'inspection et de tri selon la revendication 1 caractérisé en ce que, l'étape 4) de tri des objets à examiner est constituée par les étapes de :

analyse des défauts selon un critère de rejet qui définit une taille maximale de défauts acceptable et sélection des objets à examiner présentant des défauts acceptables.

3. Procédé d'inspection et de tri selon la revendication 2 caractérisé en ce que la taille maximale acceptable est déterminée par le calcul des projections horizontales et verticales du défaut, qui définissent une fenêtre d'analyse.

4. Procédé d'inspection et de tri selon l'une des revendications 1, 2 et 3 caractérisé en ce que l'étape d'élaboration des images $I_{ref}$ et $I_{exa}$ comporte les étapes suivantes :

saisie des images $I_{ref}$ et $I_{exa}$ de l'objet de référence et de l'objet à examiner et

seuillage des images pour obtenir les images électroniques binaires $I_{REF}$ et $I_{EXA}$.

5. Procédé d'inspection et de tri selon l'une des revendications 1, 2 et 3 caractérisé en ce que l'étape d'élaboration des images $I_{ref}$ et $I_{exa}$ comporte les étapes suivantes :

saisie de l'image $I_{exa}$ de l'objet à examiner et seuillage de cette image pour obtenir l'image électronique binaire $I_{EXA}$,

formation directe de l'image électronique binaire $I_{REF}$ soit à partir d'un générateur de configurations numérique soit à partir d'une banque de données.

6. Procédé d'inspection et de tri selon la revendication 4 ou 5 caractérisé en ce qu'il comporte en outre une étape de cadrage des images électroniques binaires $I_{REF}$ et $I_{EXA}$ correspondant à un cadrage optique des images $I_{ref}$ et $I_{exa}$.

7. Procédé d'inspection et de tri selon l'une des revendications 4, 5 et 6, caractérisé en ce que l'étape de saisie fournit une(des) image(s) analogique(s) en noir et blanc avec tous les niveaux de gris.

8. Procédé d'inspection et de tri selon la revendication 7 caractérisé en ce que l'étape de saisie comporte en outre une étape de discrétisation de l'image pour ne garder que 16 niveaux de gris.

9. Procédé d'inspection et de tri selon la revendication 8 caractérisé en ce que l'étape de seuillage comporte la détermination du seuil qui est effectué à partir de l'histogramme des intensités des points de l'image, cette détermination étant effectuée à l'aide d'un programme informatique.

10. Procédé d'inspection et de tri selon l'une des revendications ci-dessus caractérisé en ce qu'il comporte en outre une étape de nettoyage, c'est-à-dire d'élimination du bruit des images électroniques binaires $I_{REF}$ et $I_{EXA}$, effectuée avant l'étape de formation des images des défauts, et consistant dans une opération d'érosion, dont l'élément structurant, dit élément structurant de nettoyage, à une taille inférieure à la taille du plus petit défaut que l'on doit détecter, suivie par une opération de dilatation de même grandeur utilisant ledit élément structurant de nettoyage.

11. Procédé selon l'une des revendications 1 à 10, caractérisé en ce qu'on utilise un calculateur numérique (30) qui contrôle l'ensemble desdites étapes.

12. Appareil pour la mise en œuvre du procédé selon la revendication 1, cet appareil permettant la comparaison de l'image $I_{ref}$ d'un objet de référence et de l'image $I_{exa}$ d'un objet à examiner, ce dernier étant susceptible de présenter des défauts géométriques par rapport à l'objet de référence, ledit appareil comportant :

1) des moyens de saisie (22) d'au moins l'image $I_{exa}$ de l'objet à examiner,

2) des premiers moyens d'élaboration (28, 30, 32) apte à fournir, à partir de la saisie de l'image $I_{exa}$, une image de l'objet à examiner sous forme électronique binaire référencée par $I_{EXA}$ et apte à fournir une image de l'objet de référence sous forme électronique binaire référencée par $I_{REF}$,

et étant caractérisé en ce qu'il comporte en outre

3) des moyens de traitement (41) qui comprennent des deuxièmes moyens d'élaboration (47, 56) aptes à fournir, à partir de $I_{REF}$ des images électroniques $I_{REF\ max}$ et $I_{REF\ min}$ qui sont respectivement les images dilatées et érodées de $I_{REF}$ par un élément structurant, dit élément structurant de tolérance, préalablement défini et directement lié auxdites tolérances dimensionnelles, des moyens de comparaison (66A, 66B) pour la formation des images des défauts du genre manque et du genre extension en réalisant respectivement les opérations logiques

$$[I_{REF\ max}\ OU\ I_{EXA}]\ OU\ EXC\ I_{REF\ max}\ et$$

$$[I_{REF\ min}\ OU\ I_{EXA}]\ OU\ EXC.\ I_{EXA},$$

et des moyens d'analyse des défauts (70A, 70B) au vu de critères de rejet préalablement déterminés et 4) des moyens de sélection et de tri (95) des objets à examiner comportant des défauts acceptables par rapport auxdits critères de rejet.

13. Appareil selon la revendication 12 caractérisé en ce que les moyens de saisie (22) sont choisis dans le groupe comprenant : les microscopes électroniques, les caméras de télévision, les réseaux de photodiodes, et les réseaux à charges couplées.

14. Appareil selon la revendication 12 ou 13 caractérisé en ce que lesdits premiers moyens d'élaboration comportent une unité de détection de seuil et de seuillage (28, 32).

15. Appareil selon l'une des revendications 12, 13 et 14 caractérisé en ce qu'il comporte en outre : des moyens de calcul (34) pour assurer le recadrage des images électroniques binaires $I_{REF}$ et $I_{EXA}$.

16. Appareil selon l'une des revendications 12 à 15 caractérisé en ce que lesdits critères de rejet sont basés sur les projections maximales de l'image des défauts sur l'axe des x et l'axe des y à ne pas dépasser, afin de vérifier qu'un défaut n'est acceptable, que s'il est bien contenu dans une fenêtre d'analyse dont les côtés correspondent à ces projections maximales.

17. Appareil selon l'une des revendications 12 à 16, caractérisé en ce qu'il comporte en outre un calculateur numérique (30) qui contrôle l'ensemble desdits moyens.

18. Appareil selon l'une des revendications 12 à 17 caractérisé en ce que les objets de référence et/ou à examiner sont constitués par des modules présentant une configuration de lignes conductrices formée à la surface d'un substrat en céramique.

## Claims

1. A process for inspecting and automatically sorting objects to be examined showing patterns provided with constant dimensional tolerances for the more particularly related application of the type including the comparison of image $I_{ref}$ of a reference object with image $I_{exa}$ of an object to be examined, the latter being able to show geometrical defects with respect to the reference object, said process including the following step

1) elaborating images $I_{ref}$ and $I_{exa}$ as binary electronic images referenced $I_{REF}$ and $I_{EXA}$, respectively, and being characterized in that it further comprises the following steps :

2) defining a structuring element also called tolerance structuring element, directly linked to the dimensional tolerances and forming images $I_{REF}$ and $I_{REF\ min}$ which respectively consist in binary electronic image $I_{REF}$ expanded and eroded by said tolerance structuring element,

3) forming the images of the « speading » or « lack » type defects by respectively carrying out the following logic operations :

$$[I_{REF\ max}\ OR\ I_{EXA}]\ EXCL.\ OR\ I_{REF\ max}\ and$$

$$[I_{REF\ min}\ OR\ I_{EXA}]\ EXCL.\ OR\ I_{EXA}\ and$$

4) sorting the objects to be examined for selecting the ones without any defect images.

2. Inspecting and sorting process as set forth in claim 1 characterized in that step 4) for sorting the objects to be examined consists in the following sub steps :

analysing the defects with respect to a reject criterion which defines a maximum allowed size for the defects and selecting the objects to be examined showing acceptable defects.

3. Inspecting and sorting process as set forth in claim 2, characterized in that the maximum allowed size is determined by calculating horizontal and vertical projections of the defect, which define an analysis window.

4. Inspecting and sorting process as set forth in any one of claims 1, 2 and 3, characterized in that the step provided for constructing images $I_{ref}$ and $I_{exa}$ comprises the following steps :

picking up images $I_{ref}$ and $I_{exa}$ of the reference object and of the object to be examined, and thresholding the images to obtain electronic binary images $I_{REF}$ and $I_{EXA}$,

5. Inspecting and sorting process as set forth in any one of claims 1, 2 and 3, characterized in that the step provided for constructing images $I_{ref}$ and $I_{exa}$ comprises the following steps :

picking up image $I_{exa}$ of the object to be examined and thresholding this image to obtain binary electronic image $I_{EXA}$,

directly constructing binary electronic image $I_{REF}$ either from a digital pattern generator or from a data bank.

# 0 054 598

6. Inspecting and sorting process as set forth in claim 4 or 5, characterized in that it further includes a step for centering binary electronic images $I_{REF}$ and $I_{EXA}$, which corresponds to the optical centering of images $I_{ref}$ and $I_{exa}$.

7. Inspecting and sorting process as set forth in any one of claims 4, 5 and 6, characterized in that the picking up step provides analog images in black and white with all the grey levels.

8. Inspecting and sorting process as set forth in claim 7, characterized in that the picking up step further includes a step for discretizing the image to retain only 16 grey levels.

9. Inspecting and sorting process as set forth in claim 8, characterized in that the thresholding step includes threshold determination which is performed from the image point intensity histogram, said determination being carried out by using a program.

10. Inspecting and sorting process as set forth in any one of the above claims, characterized in that it further includes a cleaning step, i. e. a step for suppressing noise from binary electronic images $I_{REF}$ and $I_{EXA}$, performed prior to the defect image constructing step and consisting in an erode operation the structuring element of which, also called cleaning structuring element, being smaller than the size of the smallest defect which is to be detected, followed by an expand operation of the same size using said cleaning structuring element.

11. Process according to any one of claims 1 to 10, characterized in that one uses a digital computer (30) controlling all said steps.

12. An apparatus for carrying out the process of claim 1, this apparatus comparing image $I_{ref}$ of a reference object and image $I_{exa}$ of an object to be examined, the latter being likely to show geometrical defects with respect to the reference object, said apparatus including :

1) means (22) for picking up at least image $I_{exa}$ of the object to be inspected,

2) first constructing means (28, 30, 32) capable of producing from the picking up of image $I_{exa}$, a binary electronic image $I_{EXA}$ of the object to be inspected and capable of producing a binary electronic image $I_{REF}$ of the reference object, and being characterized in that it further includes :

3) processing means (41) including second constructing means (47, 58) capable of providing from $I_{REF}$, electronic images $I_{REF\ max}$ and $I_{REF\ min}$ which, respectively, are the images of $I_{REF}$ expanded and broded by a structuring element also called tolerance structuring element previously defined and directly linked to sais dimensional tolerances, compare means (66A, 66B) for constructing images of the lack and speading type defects by performing the following logic operations :

$$[I_{REF\ max}\ OR\ I_{EXA}]\ EXCL.\ OR\ I_{REF\ max}\ and$$

$$[I_{REF\ min}\ OR\ I_{EXA}]\ EXCL.\ OR\ I_{EXA}$$

and means for analysing defects (70A, 70B) with respect to predetermined reject criteria and

4) means (95) for selecting and sorting the objects to be inspected showing defects which can be tolerated with respect to the reject criteria.

13. Apparatus as set forth in claim 12, characterized in that pick up means (22) are chosen from the group including the electron microscopes, TV cameras, photodiode arrays and charge coupled devices.

14. Apparatus as set forth in claim 12 or 13, characterized in that said first constructing means comprise a threshold detection and thresholding unit (28, 32).

15. Apparatus as set forth in any one of claims 13 and 14, characterized in that it further includes : compute means (34) for recentering binary electronic images $I_{REF}$ and $I_{EXA}$.

16. Apparatus as set forth in any one of claims 12 to 15, characterized in that said reject criteria are based upon the maximum allowed projections of the defect image along axis x and y, in order to check that a defect can be accepted only if it is really contained within an analysis window the sides of which correspond to said maximum projections.

17. Apparatus as set forth in any one of claims 12 to 16, characterized in that it further includes a digital computer (30) which controls all said means.

18. Apparatus as set forth in any one of claims 12 to 17, characterized in that the reference objects and/or the objects to by inspected in modules showing a pattern of conducting lines provided on the surface of a ceramic substrate.

## Ansprüche

1. Verfahren zum Untersuchen und automatischen Sortieren von Objekten bestimmter Gestalt mit festen dimensionalen Toleranzen für eine besondere Anwendung, die einen Vergleich des Bildes $I_{ref}$ eines Bezugsgegenstandes und des Bildes $I_{exa}$ eines zu untersuchenden Gegenstandes enthält, wobei dieser letztere geometrische Fehler in Bezug auf den Bezugsgegenstand aufweisen kann, mit den Stufen :

1) der Erzeugung der Bilder $I_{ref}$ und $I_{exa}$ in Form elektronischer binärer Bilder, mit $I_{REF}$ bzw. $I_{EXA}$, bezeichnet,

dadurch gekennzeichnet, dass es ausserdem die folgenden Stufen enthält :

14

**0 054 598**

2) Definition eines strukturierenden Elementes, dem sogenannten toleranzstrukturierenden Element, das direkt an die Abmessungs- und Entstehungstoleranzen der Bilder $I_{REF\,max}$ und $I_{REF\,min}$ gebunden ist, welche das binäre elektronische Abbild von $I_{REF}$ darstellen, vergrössert oder verkleinert durch das sogenannte toleranzstrukturierende Element.

3) Erzeugung der Fehlerbilder vom Typ zu viel oder zu wenig, in dem die folgenden logischen Operationen durchgeführt werden

$$(I_{REF\,max} \text{ ODER } I_{EXA}) \text{ ODER EXC. } I_{REF\,max} \text{ und}$$

$$(I_{REF\,min} \text{ ODER } I_{EXA}) \text{ ODER EXC. } I_{EXA} \text{ und}$$

4) Sortieren der zu prüfenden Gegenstände für die Auswahl derer, die fehlerfreie Bilder aufweisen.

2. Verfahren zum Untersuchen und Sortieren gemäss Anspruch 1, dadurch gekennzeichnet, dass die Etappe 4 der Sortierung der zu prüfenden Objekte aus folgenden Etappen besteht :

Fehleranalyse nach einem Abweisungskriterium, das eine maximal akzeptierbare Fehlergrösse festlegt, und Auswahl der zu untersuchenden Objekte, die annehmbare Fehler aufweisen.

3. Verfahren zum Untersuchen und Sortieren von Objekten gemäss Anspruch 2, dadurch gekennzeichnet, dass die maximal akzeptierbare Grösse durch die Berechnung der horizontalen und vertikalen Fehlerprojektionen ermittelt wird, welche ein Analysefenster festlegen.

4. Verfahren zum Untersuchen und Sortieren von Objekten gemäss einem der Ansprüche 1, 2 und 3, dadurch gekennzeichnet, dass die Ausarbeitungsstufe der Bilder $I_{ref}$ und $I_{exa}$ folgende Stufen enthält :

Erfassung der Bilder $I_{ref}$ und $I_{exa}$ des Bezugsobjektes und des zu untersuchenden Objektes und Erzeugung von Bildschwellen, um binäre elektronische Bilder $I_{REF}$ und $I_{EXA}$ zu erhalten.

5. Verfahren zum Untersuchen und Sortieren von Objekten gemäss einem der Ansprüche 1, 2 und 3, dadurch gekennzeichnet, dass die Herstellungsphase der Bilder $I_{ref}$ und $I_{exa}$ folgende Stufen enthält :

Erfassung des Bildes $I_{exa}$ des zu untersuchenden Objektes und Erzeugung von Schwellen dieses Bildes für den Erhalt des binären elektronischen Bildes $I_{EXA}$,

direkte Bildung des binären elektronischen Bildes $I_{REF}$, entweder von einem Generator numerischer Konfigurationen aus, oder von einer Datenbank aus.

6. Verfahren zum Untersuchen und Sortieren von Objekten gemäss Anspruch 4 oder 5, dadurch gekennzeichnet, dass es ausserdem eine Etappe der Ausrichtung der elektronischen binären Bilder $I_{REF}$ und $I_{EXA}$ enthält, die einer optischen Ausrichtung der Bilder $I_{ref}$ und $I_{exa}$ entspricht.

7. Verfahren zum Untersuchen und Sortieren und Untersuchen von Objekten gemäss einem der Ansprüche 4, 5 und 6, dadurch gekennzeichnet, dass die Erfassungsstufe eines oder mehrere Analogbilder in Schwarzweiss mit allen Grauschattierungen ergibt.

8. Verfahren zum Untersuchen und automatischen Sortieren von Objekten gemäss Anspruch 7, dadurch gekennzeichnet, dass die Erfassungsstute ausserdem eine Stufe der Diskretisierung des Bildes gibt, um nur 16 Graustufen zu erhalten.

9. Verfahren zum Untersuchen und Sortieren von Objekten gemäss Anspruch 8, dadurch gekennzeichnet, dass die Schwellenbildungsstufe die Ermittlung der Schwelle enthält, die sich aus dem Histogramm der Stärken der Bildpunkte ergibt, wobei diese Bestimmung mit Hilfe eines Datenverarbeitungsprogrammes vorgenommen wird.

10. Verfahren zum Untersuchen und Sortieren von Objekten gemäss einem der oben genannten Ansprüche, dadurch gekennzeichnet, dass es ausserdem eine Reinigungsstufe enthält, d. h. die Ausscheidung des Rausches der elektronischen Binärbilder $I_{REF}$ und $I_{EXA}$, vorgenommen vor der Stufe der Erzeugung der Fehlerbilder, bestehend aus einem Erosionsvorgang, dessen strukturierendes Element, das sogenannte strukturierende Reinigungselement, eine Grösse besitzt, die unter der Grösse des kleinsten zu erfassenden Fehlers liegt, und auf die eine Ausweitungsoperation der gleichen Grösse folgt, welche das sogenannte strukturierende Reinigungselement verwendet.

11. Verfahren gemäss einem der Ansprüche 1 bis 10, dadurch gekennzeichnet, dass ein digitaler Rechner (30) verwendet wird, der die Gesamtheit der besagten Stufen kontrolliert.

12. Einrichtung für den Einsatz des Verfahrens gemäss Anspruch 1, für den Vergleich des Bildes $I_{ref}$ eines Bezugsobjektes und des Bildes $I_{exa}$ eines zu untersuchenden Objektes, wobei dieses letztere geometrische Fehler gegenüber dem Bezugsobjekt aufweisen kann, mit :

1) Erfassungsmitteln (22) mindestens für das Bild $I_{exa}$ des zu untersuchendern Objektes.

2) Erste Ausarbeitungsmittel (28, 30, 32) für die Erzeugung eines Bildes des zu untersuchenden Gegenstandes, ausgehend von dem erfassten Bild $I_{exa}$, in durch $I_{EXA}$ referenzierter elektronischer binärer Form, geeignet, ein Bild des Bezugsobjektes in elektronischer binärer Form, referenziert durch $I_{REF}$ zu liefern,

und dadurch gekennzeichnet, dass es ausserdem enthält :

3) Verarbeitungsmittel (41), welche zweite Erzeugungsmittel (47, 56) enthalten, die in der Lage sind, ausgehend von $I_{REF}$ elektronische Bilder $I_{REF\,max}$ und $I_{REF\,min}$ zu liefern, die die durch ein trukturierendes Element, das sogenannte toleranzstrukturierende Element erweiterten bzw. eingeengten Bilder von $I_{REF}$ sind, vorher festgelegt und direkt an die besagten Abmessungstoleranzen gebunden, Vergleichsmittel (66A, 66B) für die Bildung der Fehlerbilder vom Typ zuviel und zu wenig, durch Ausführung folgender logischer Operationen

$$(I_{REF\,max}\ \text{oder}\ I_{EXA})\ \text{ODER EXC}\ I_{REF\,max}\ \text{und}$$

$$(I_{REF\,min}\ \text{ODER}\ I_{EXA})\ \text{ODER EXC.}\ I_{EXA},$$

und Fehleranalysemittel (70A, 70B) entsprechend den vorher bestimmten Zurückweisungskriterien und

4) Mittel für die Auswahl und Sortierung (95) der zu untersuchenden Objekte, welche akzeptierbare Fehler enthalten, bezogen auf die besagten Zurückweisungskriterien.

13. Einrichtung gemäss Anspruch 12, dadurch gekennzeichnet, dass die Erfassungsmittel (22) in der Gruppe gewählt werden, welche enthält : die Elektronenmikroskope, die Fernsehkkameras, die Fotodiodennetze, und die Netze mit gekoppelten Lasten.

14. Einrichtung gemäss Anspruch 12 oder 13, dadurch gekennzeichnet, dass die besagten ersten Erzeugungsmittel eine Schwellendetektions- und eine Schwellenbildungseinheit (28, 32) enthalten.

15. Einrichtung gemäss einem der Ansprüche 12, 13 und 14, dadurch gekennzeichnet, dass sie ausserdem enthält :

Berechnungsmittel (34), um die Neuausrichtung der elektronischen Binärbilder $I_{REF}$ und $I_{EXA}$ zu gewährleisten.

16. Einrichtung gemäss einem der Ansprüche 12 bis 15, dadurch gekennzeichnet, dass die besagten Abweisungskriterien auf maximalen Projektionen des Bildes der Fehler auf die x-Achse und die y-Achse beruhen, die nicht überschritten werden dürfen, um zu prüfen, dass ein Fehler nicht akzeptierbar ist, ausser wenn er ein Analysefenster nicht überschreitet, dessen Seiten diesen maximalen Projektionen entsprechen.

17. Einrichtung gemäss einem der Ansprüche 12 bis 16, dadurch gekennzeichnet, dass sie ausserdem einen digitalen Rechner (30) enthält, der die Gesamtheit der besagten Mittel überprüft.

18. Einrichtung gemäss einem der Ansprüche 12 bis 17, dadurch gekennzeichnet, dass die Bezugsgegenstände und/oder die zu untersuchenden Objekte durch Moduln gebildet sind, welche eine Anordnung leitender Linien aufweisen, die nach der Oberfläche eines Keramiksubstrats gebildet ist.

**0 054 598**

FIG. 1

# FIG . 2

**Axis labels:** NOMBRE DE POINTS IMAGES (vertical); NIVEAUX DE GRIS (horizontal)

500 000 · 400 000 · 300 000 · 200 000 · 100 000

0 1 2 3 4 5 6 7 8 9 10 11 12 13 14 15

$N_{TH1}$

Curves labelled 8, 7, 7', 7''

# FIG. 3

$M_X$, $Y_1$, $Y_1 + P$, MOTIF $I_{EXA}$, MOTIF $I_{REF}$, X, Y, 0

2

# FIG.4

# FIG.5

FIG.6

FIG . 7

A          B                    C

FIG . 8

A          B          C          D

FIG.9

IMAGES DES DEFAUTS

FIG. 10

# FIG.11A

# FIG.11B

# FIG.11C

FIG. 11D

# FIG. 12